# EUROPÄISCHE PATENTSCHRIFT

(11) **EP 0 894 341 B1**
(45) Veröffentlichungstag und Bekanntmachung des Hinweises auf die Patenterteilung: **10.11.1999**
(21) Anmeldenummer: 97916337.5
(22) Anmeldetag: 10.03.1997
(51) Int. Cl.: H01L 41/24, H01L 41/083, C04B 35/472

(54) **MONOLITHISCHER VIELSCHICHT-PIEZOAKTOR UND VERFAHREN ZUR HERSTELLUNG**
MONOLITHIC MULTILAYER PIEZOELECTRIC ACTUATOR AND ITS PROCESS OF PRODUCTION
ELEMENT PIEZO-ELECTRIQUE MONOLITHIQUE D'ACTIONNEMENT A COUCHES MULTIPLES ET SON PROCEDE DE FABRICATION

(30) Priorität: 19.04.1996 DE 19615695
(43) Veröffentlichungstag der Anmeldung: 03.02.1999
(73) Patentinhaber: SIEMENS AKTIENGESELLSCHAFT, 80333 München (DE)
(72) Erfinder: CRAMER, Dieter, D-83607 Holzkirchen (DE); HELLEBRAND, Hans, D-81669 München (DE); LUBITZ, Karl, D-85521 Ottobrunn (DE)
(86) Internationale Anmeldenummer: DE9700463
(87) Internationale Veröffentlichungsnummer: WO9740537

(56) Entgegenhaltungen:
- WO-A-92/17420
- PATENT ABSTRACTS OF JAPAN Bd. 012, Nr. 285 (E-642) 04 August 1988 & JP 63 062 280 A (TOYOTA MOTOR CORP) 18 März 1988
- PATENT ABSTRACTS OF JAPAN Bd. 014, Nr. 018 (E-873) 16 Januar 1990 & JP 01 260 870 A (TORAY IND INC) 18 Oktober 1989

## Beschreibung

Piezoaktoren bestehen üblicherweise aus mehreren in einem Stapel angeordneten Piezoelementen. Jedes dieser Elemente wiederum besteht aus einer Piezokeramikschicht, die beiderseits mit metallischen Elektroden versehen ist. Wird an diese Elektroden eine Spannung angelegt, so reagiert die Piezokeramikschicht mit einer Gitterverzerrung, die entlang einer Hauptachse zu einer nutzbaren Längenausdehnung führt. Da diese wiederum weniger als zwei Promille der Schichtdicke entlang der Hauptachse beträgt, muß zur Erzielung einer gewünschten absoluten Längenausdehnung eine entsprechend höhere Schichtdicke aktiver Piezokeramik bereitgestellt werden. Mit zunehmender Schichtdicke der Piezokeramikschicht innerhalb eines Piezoelementes steigt jedoch auch die zum Ansprechen des Piezoelementes erforderliche Spannung. Um diese in handhabbaren Grenzen zu erhalten, liegen die Dicken von Piezoeinzelelementen in Mehrschichtaktoren üblicherweise zwischen 20 und 200 µm. Ein Piezoaktor muß für eine gewünschte Längenausdehnung daher eine entsprechende Anzahl an Einzelelementen bzw. -schichten aufweisen.

Bekannte Piezoaktoren in Vielschichtbauweise bestehen daher aus bis zu einigen hundert Einzelschichten. Diese können zu einem Stapel angeordnet und beispielsweise verklebt werden. Aus der US-5 438 232 ist ein Verfahren zum Herstellen von Mehrschichtaktoren durch Verkleben von Einzelaktoren mit Hilfe eines Harzes bekannt. Ein solcher geklebter Stapel zeigt jedoch für viele Anwendung eine zu geringe Steifigkeit, insbesondere wenn mit dem Piezoaktor hohe Kräfte übertragen werden müssen. Ausreichend hohe Steifigkeiten besitzen Piezoaktoren in monolithischer Vielschichtbauweise. Zu deren Herstellung werden Piezokeramikgrünfolien alternierend mit Elektrodenmaterial zu einem Stapel angeordnet und gemeinsam gesintert. Nur so kann ein ausreichend fester Verbund der Einzelschichten im Stapel erzielt werden. Aus einem Artikel von H. Moilanen et al in der Zeitschrift Sensors and Actuators A, 43 (1994) 357 bis 365 ist ein Verfahren zum Herstellen eines Mehrschichtpiezoaktors bekannt, bei dem sowohl die Keramik- als auch die Elektrodenschichten durch alternierendes Übereinanderaufdrucken erzeugt werden. In regelmäßigen Intervallen ist dabei ein Trocknen bzw. ein Vorsintern bei Temperaturen bis 750°C erforderlich.

Aus einem Artikel von S. Takahashi et al in Ferroelectrics, 1983, Vol. 90. Seiten 181 bis 190, ist ein Verfahren zum Herstellen eines Mehrschichtaktors bekannt, der durch Übereinanderstapeln und Laminieren von mit Elektrodenschichten bedruckten keramischen Grünfolien und abschließendes Sintern des Stapels erhalten wird.

Bei der Herstellung monolithischer Vielschichtpiezoaktoren müssen bei der Einstellung der Verfahrensbedingungen insbesondere beim Sinterprozeß die Materialeigenschaften sowohl der Piezokeramik als auch des Elektrodenmaterials berücksichtigt werden. Probleme bereitet beispielsweise die optimale Sintertemperatur für Piezokeramik, die zur Erzielung optimaler Korngrößen und damit optimaler piezoelektrischer Eigenschaften in Abhängigkeit von der Zusammensetzung der Piezokeramik bei über 1250°C liegen kann. Bei einer solch hohen Sintertemperatur läßt sich nur Platin als Elektrodenmaterial verwenden. Dieses zeigt eine schwache Wechselwirkung mit der Keramik und läßt sich mit den meisten Piezokeramikmaterialien zusammen verwenden. Nachteilig sind jedoch die hohen Materialkosten für Platin, sowie die begrenzte Festigkeit an der Grenzfläche zwischen Elektrode und Piezokeramik.

Verwendet man als Elektrodenmaterial das kostengünstige und bei Vielschichtkondensatoren übliche Ag/Pd, so ist die Sintertemperatur durch den Schmelzpunkt der Legierung begrenzt, der beispielsweise (bei Ag/Pd 70/30) unter 1130°C liegen kann. Damit ist man auf Piezokeramikmaterialien beschränkt, deren optimale Sintertemperatur maximal beim Schmelzpunkt der Legierung liegt. Solche Piezokeramiken enthalten zur Herabsetzung der optimalen Sintertemperatur B-Platz Dotierungen von typisch 20 bis 50 Prozent zum Bleizirkonattitanat (PZT)-Grundmaterial. Als Nachteil muß bei diesen Keramiken eine erniedrigte Curietemperatur in Kauf genommen werden, die die maximale Anwendungstemperatur des Piezoaktors begrenzt. Außerdem zeigt sich auch bei dieser Materialkombination eine begrenzte Festigkeit im Stapel an der Grenzfläche Piezokeramik/Elektrode.

Aufgabe der vorliegenden Erfindung ist es daher, ein Herstellverfahren für einen Piezoaktor in monolithischer Vielschichtbauweise anzugeben, welcher nicht auf Piezokeramikmaterial mit niedriger Curie- und Anwendungstemperatur begrenzt ist, welcher trotzdem gute piezoelektrische Eigenschaften zeigt und welcher außerdem eine hohe mechanische Verbundfestigkeit besitzt.

Diese Aufgabe wird erfindungsgemäß mit einem Verfahren nach Anspruch 1 gelöst. Besondere Ausgestaltungen der Erfindung sind weiteren Ansprüchen zu entnehmen.

Mit der Erfindung wird erstmals ein Piezoaktor hergestellt, der unabhängig von einer gegebenenfalls vorhandenen Dotierung auf einem B-Platz mit einer Silber/Palladium-haltigen Elektrodenschicht optimale Korngrößen in den Piezokeramikschichten aufweist. Die Piezoaktoren besitzen die optimalen Werte, die man von einer unter optimalen Bedingungen und getrennt von der Elektrodenschicht gesinterten Piezokeramikschicht der gleichen Zusammensetzung kennt und erwartet. Dabei weist der Piezoaktor eine monolithische Bauweise auf, bei der Piezokeramikgrünfolien und Elektrodenschichten gemeinsam gesintert wurden und daher eine hohe Festigkeit in der Verbindung zwischen Elektrodenschicht und Keramikschicht aufweisen. Die zum Beispiel aus einer Silber/Palladium-Legierung bestehende Elektrodenschicht bleibt beim Sinterprozeß unversehrt, da dieser unterhalb der Schmelztemperatur des Elektrodenmaterials durchgeführt werden kann. Überraschend ist insbesondere, daß auf diese Weise auch ein Piezoaktor erhalten werden kann, der eine niedrige oder ganz fehlende B-Platzdotierung, kostengünstige Silber/Palladium-Elektrodenschichten, hohe Korngrößen und gute piezoelektrische Eigenschaften der Piezokeramikschichten bei gleichzeitiger hoher Verbundfestigkeit der Einzelschichten im Stapel miteinander vereint. Auf diese Weise können insbesondere auch Piezoaktoren erhalten werden, die eine hohe Curietemperatur besitzen, was einen Einsatz des Piezoaktors bei höheren Einsatztemperaturen ermöglicht. Dies war bisher nicht bekannt, da Piezokeramiken mit hohen Curie-Temperaturen höhere Sintertemperaturen erfordern, als mit dem niedrigen Schmelzpunkt der verwendeten Elektrodenschichten bislang möglich waren. Nicht optimale Sinterbedingungen bei zu niedriger Sintertemperatur behindern aber das Kornwachstum und ergeben Piezokeramiken mit schlechten piezoelektrischen Eigenschaften. Gute piezoelektrische Eigenschaften dagegen werden erhalten, wenn wie beim erfindungsgemäßen Piezoaktor die Korngrößen der Piezokeramikschichten im gleichen Bereich von 2 bis 10 um liegen, wie er bei der Sinterung der Keramik allein, das heißt ohne Elektroden, mit höherer optimaler Sintertemperatur erreicht wird.

Zur ebenfalls erfindungsgemäßen Herstellung des Piezoaktors wird von einem bekannten Verfahren zum Herstellen monolithischer Mehrschichtbauelemente ausgegangen, bei dem mit Elektrodenmaterial versehene Piezokeramik-Grünfolien alternierend übereinander gestapelt und anschließend zusammengesintert werden. Erfindungsgemäß wird von einem Piezokeramikpulver des Typs Bleizirkonattitanat (PZT) ausgegangen, welches eine stöchiometrische Zusammensetzung aufweist. Zusätzlich zu dieser stöchiometrischen Zusammensetzung wird ein geringer Anteil eines heterovalenten A-Platz Dotierstoffs in Höhe von 1 bis 5 Mol-Prozent sowie ein weiterer Überschuß von zusätzlichen 1 bis 5 Mol-Prozent Bleioxid zugegeben. Außerdem wird ein Silber- und Palladium-haltiges Elektrodenmaterial verwendet. Der Stapel wird anschließend laminiert und unter kontrollierten Bedingungen in oxidierender Atmosphäre gesintert, wobei die Sintertemperatur maximal den Schmelzpunkt des Silber- und Palladium-haltigen Elektrodenmaterials erreichen darf. Die Sinterung wird so durchgeführt, daß stöchiometrisch überschüssiges Bleioxid abdampft und daß außerdem Silber aus den Elektrodenschichten in die Piezokeramikschichten eindiffundiert, wobei eine stöchiometrische Piezokeramikzusammensetzung erhalten wird.

Die Erfindung geht auf die überraschende Erkenntnis zurück, daß eine überstöchiometrische A-Platz-Dotierung, beispielsweise durch ein höherwertiges Selten-Erden-Metall, während des Sinterverfahrens durch Eindiffusion von Silber aus den Elektrodenschichten ausgeglichen werden kann. Voraussetzung dafür ist jedoch, daß dabei gleichzeitig ein stöchiometrischer Überschuß an Bleioxid vorliegt. Als Erklärung dafür wird vermutet, daß überschüssiges Bleioxid während des Sinterprozesses flüssige Phasen innerhalb des sich ausbildenden Piezokeramikgefüges erzeugt, die die Eindiffusion von Silber unterstützen. Überraschend ist ferner, daß der Diffusionsprozeß des Silbers quasi selbstregulierend ist. Triebkraft für den Diffusionsprozeß ist die heterovalente Fehlbesetzung der A-Plätze im PZT-Kristallgitter, die durch das einwertige Silber ausgeglichen werden. Bei Erreichen einer stöchiometrischen Zusammensetzung entfällt die Triebkraft, so daß weitere Eindiffusion von Silber unterbleibt. Überraschend an dem Verfahren ist weiterhin, daß trotz einer maximalen Sintertemperatur von beispielsweise 1130°C für eine 70/30 Silber/ Palladium-Legierung hohe Korngrößen in der Piezokeramik erhalten werden. Es wird vermutet, daß der Einbau des Silbers in die Piezokeramik das Kornwachstum unterstützt. Trotz einer um 150 bis 200° erniedrigten Sintertemperatur werden solch hohe Korngrößen und gute piezoelektrische Werte erzielt, wie in einem bei optimalen Bedingungen und ohne Elektroden gesinterten Bauteil, bei dem entsprechend höhere Sintertemperaturen gewählt werden können. Auch das Erreichen einer optimalen Dichte von zumindest 96 Prozent wird zu niederen Temperaturen hin verschoben.

Durch den in Piezokeramikpulver eingestellten Bleioxidüberschuß wird ein weiteres vorteilhaftes Ergebnis erzielt. An der Grenzfläche Piezokeramik/Elektrodenschicht bildet sich durch Eindiffusion von Palladium eine Pd-Pb-O-haltige Phase aus, die nach der Sinterung im Grenzflächenbereich in Korngrenzzwickeln nachgewiesen werden kann. Es wird vermutet, daß diese Phasen für die festgestellte verbesserte Haftung zwischen Keramik- und Elektrodenschichten im Stapel verantwortlich sind.

In vorteilhafter Weise wird die Sinterung in oxidierender Atmosphäre durchgeführt. Ist die maximale Sintertemperatur erreicht, wird eine Haltephase bei dieser maximalen Temperatur von 30 bis 120 Minuten eingehalten.

Vorzugsweise werden unabhängig voneinander sowohl der Bleiüberschuß als auch die überschüssige A-Platz-Dotierung auf 1 bis 3 Mol-Prozent eingestellt. Zur A-Platz-Dotierung wird eine Seltene Erde ausgewählt, vorzugsweise Lanthan oder Neodym.

Im folgenden wird die Erfindung anhand von zwei Ausführungsbeispielen und den dazugehörigen drei Figuren näher erläutert.
- Figur 1: zeigt einen schematischen Querschnitt durch durch einen alternierenden Piezokeramik/Elektrodenstapel nach der Sinterung,
- Figur 2: zeigt eine Meßkurve für den Silbergehalt einer Piezokeramikschicht über die Schichtdicke nach der Sinterung.
- Figur 3: zeigt ausschnittsweise einen Bereich in der Nähe der Elektrodenschicht/Piezokeramikschichtgrenzfläche nach der Sinterung.

### 1. Herstellung eines Piezoaktors aus einer Piezokeramik mit hoher Curietemperatur von 330°C.

Es wird ein Piezokeramikpulver vorbereitet, welches eine nominale Zusammensetzung Pb_{0,98} Nd_{0,02} (Zr_{0,54} Ti_{0,46}) O_{3,01} aufweist. Die möglichst homogen gemischten Ausgangsmaterialien können nach bekannten Verfahren hergestellt werden und beispielsweise nach dem Mixed Oxide-Verfahren oder auf chemischen Routen dargestellt werden, beispielsweise nach dem Sol-Gel-Verfahren, dem Citrat-Verfahren, dem Oxalat-Verfahren oder über sonstige metallorganische Vorläuferverbindungen. Während für das Mixed Oxide-Verfahren sämtliche für die Keramik vorgesehenen Kationen in Form ihrer Oxide miteinander vermischt und anschließend in PZT überführt werden, gehen andere Herstellungsverfahren von gemischten Lösungen metallorganischer Verbindungen der gewünschten Kationen aus. Durch Fällung aus Lösung oder durch allmähliches Eindicken im sogenannten Sol-Gel-Verfahren wird eine äußerst homogene Verteilung der Kationen im späteren Feststoff erzielt.

Nach der Calzinierung wird erneut gemahlen, homogenisiert und anschließend mit einem organischen Binder vermischt. Mit dem so erhaltenen Schlicker werden anschließend Grünfolien gezogen oder gegossen. Nach Trocknen der Grünfolien werden diese mit Elektrodenmaterial versehen, beispielsweise mit einer Paste bedruckt, die Partikel einer Silber/Palladium-Legierung (70/30 Masseverhältnis) in einem Binder bei insgesamt druckbarer Konsistenz enthält.

Die Piezokeramik-Grünfolien werden in einer Dicke hergestellt, die unter Berücksichtigung eines linearen Schwunds bei der Sinterung von typischerweise 15 Prozent eine Piezokeramikdicke von 20 bis 200 um ergibt. Für die Elektrodenschicht wird soviel Elektrodenmaterial aufgedruckt, daß sich nach der Sinterung eine ca. 2 bis 3 µm dicke Elektrodenschicht ergibt. Bei einem kleinen Schichtdickenverhältnis Elektrodenschicht/Piezokeramikschicht muß entsprechend mehr Elektrodenmaterial aufgedruckt werden, damit der zu einem Elektrodenmaterialverlust führende Prozeß der Silbereindiffusion kompensiert werden kann. Die Elektrodenschicht kann dabei ganzflächig oder in einem beliebigen jedoch möglichst feinen Raster aufgedruckt werden.

Die mit Elektrodenmaterial bedruckten Piezokeramik-Grünfolien werden anschließend übereinander gestapelt, wobei sich eine alternierende Anordnung von Piezokeramikschicht und Elektrodenschicht ergibt. Durch einen Laminierprozeß unter Druck und erhöhter Temperatur wird der Stapel vorverdichtet und zeigt danach bereits ausreichend Zusammenhalt, so daß er als Stapel gehandhabt werden kann. In diesem Stadium ist es auch möglich, einen Stapel größerer Grundfläche nach dem Laminieren in mehrere identische Stapel kleinerer Grundfläche aufzuteilen, beispielsweise durch Schneiden oder Stanzen. Mehrere solcher Teilstapel können wiederum zu einem größeren Stapel vereinigt werden. Die Gesamtanzahl der für den späteren Piezoaktor erforderlichen Schichten richtet sich nach der Höhe der Auslenkung, die durch Anlegen einer Spannung mit dem Piezoaktor erzielt werden soll. Da ein einzelnes Piezoelement um typisch 1 bis 2 Promille seiner Dicke ausgelenkt werden kann, läßt sich die erforderliche Anzahl der Einzelschichten für einen gewünschten Gesamthub ganz einfach über die Gesamtschichtdicke der Piezokeramikschichten (nach dem Sintern) errechnen. Für eine gewünschte Anwendung mit 20 µm Hub sind beispielsweise ca. 150 Piezokeramikeinzelschichten von ca. 100 µm Dicke ausreichend.

Nach dem Laminieren des oder der Stapel wird in oxidierender Atmosphäre bei 1130°C gesintert. Diese maximale Temperatur wird für ca. 1 Stunde gehalten und danach langsam abgekühlt.

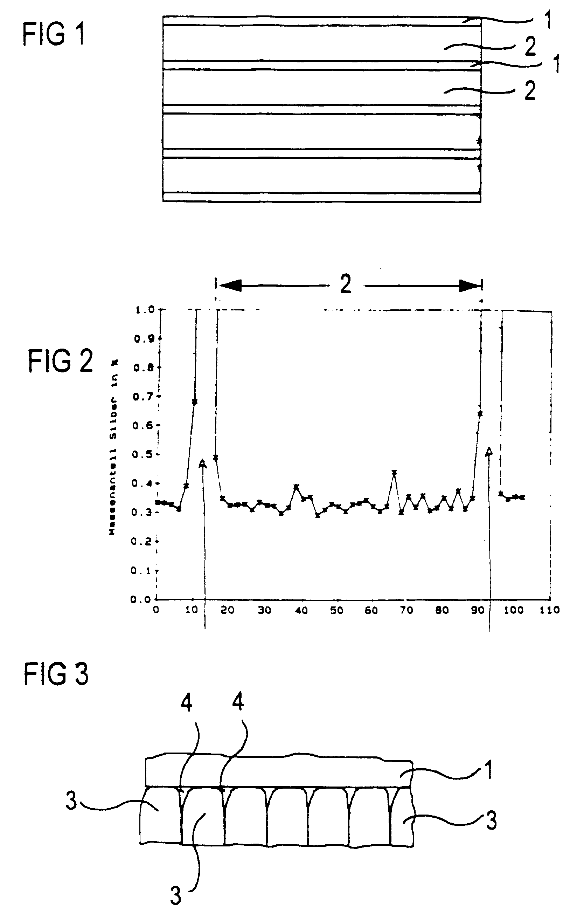

Figur 1: Es wird ein Piezoaktor erhalten, der eine hohe mechanische Verbundfestigkeit und daher eine hohe mechanische Belastbarkeit aufweist. Wie sich anhand von Querschliffen durch den Stapel zeigen läßt, sind die Elektrodenschichten 1 in sich weitgehend zusammenhängend. Es wird daher ein hoher Flächendeckungsgrad erzielt, der ein homogenes elektrisches Feld beim Anlegen einer Spannung ermöglicht. Die Piezokeramikschichten 2 weisen hohe Korngrößen von 2 µm bis 10 µm µm auf. Eine Analyse der Piezokeramik ergibt folgende Zusammensetzung: Pb_{0,96} Ag _{0,02} Nd_{0,02} (Zr_{0,54} Ti_{0,46}) O₃. Die Zusammensetzung ist nicht nur stöchiometrisch sondern auch über die gesamte Piezokeramikschicht homogen. Dies läßt sich insbesondere an einer Messung der Silberkonzentration mittels Mikroanalyse nachweisen.

Figur 2 zeigt das Profil des Silbergehalts in Abhängigkeit vom Abstand zur Grenzfläche Piezokeramikschicht/Elektrodenschicht. Es zeigt sich, daß die Silberkonzentration über die gesamte Schichtdicke äußerst homogen ist.

Figur 3 zeigt in vergrößerter schematischer Querschnittsdarstellung den Grenzflächenbereich Elektrodenschicht/Piezokeramikschicht. Gut zu erkennen ist die Körnung 3 der Piezokeramikschicht. Die Korngrenzzwickel 4 an der Grenzfläche zur Elektrodenschicht 1, also die geometrisch durch die Form der Keramikkörner vorgegebenen Zwischenräume weisen eine Phase auf, in der sich Palladium, Blei und Sauerstoff nachweisen läßt. Diese Phase kann bis zu einer Entfernung von 50 nm bis zu einigen µm von der Grenzfläche zur Elektrodenschicht nachgewiesen werden. Es wird angenommen, daß die Elektrodenschicht 1 mit Hilfe dieser Phase mit der Piezokeramikschicht 2 verzahnt und zu deren erfindungsgemäß erhöhter Festigkeit beiträgt. Tiefer innerhalb der Piezokeramikschicht oder etwa in den Piezokeramikkörnern 3 kann kein Palladium nachgewiesen werden.

Der Piezoaktor dieser Zusammensetzung ist für Anwendungstemperaturen bis ca. 150° C geeignet.

Herstellung einer Piezokeramikschicht mit niedriger Curietemperatur von 170°C.

Es wird ein Piezokeramikpulver der nominalen Zusammensetzung Pb_{0,99} La_{0,01} {Zr_{0,30} Ti_{0,36} (Ni_{1/3} Nb_{2/3})_{0,34}}O_{3,005} nach bekannten Methoden hergestellt. Entsprechend dem ersten Ausführungsbeispiel werden daraus Grünfolien bereitet, mit Elektrodenmaterial versehen, zu den entsprechenden Stapeln geschichtet, laminiert und bei gleichen Bedingungen gesintert. Es wird ein Piezoaktor von hoher Festigkeit erhalten, für den eine Curietemperatur von 170°C bestimmt wird. Damit kann dieser Aktor in einem Temperaturbereich bis maximal ca. 80°C verwendet werden. Die Piezokeramikschichten 2 weisen nach der Sinterung die folgende stöchiometrische Zusammensetzung auf: Pb_{0,98} Ag_{0,01} La_{0,01} {Zr_{0,30} Ti_{0,36} (Ni_{1/3} Nb_{2/3})_{0,34}}O₃.

Diese Piezokeramik bzw. der daraus hergestellte Piezoaktor in Mehrschichtbauweise besitzt, wie aus der Formel erkenntlich, eine komplexe Dotierung für den B-Platz. Dadurch wird eine Piezokeramik mit verbesserten piezoelektrischen Eigenschaften erhalten, die insbesondere eine erhöhte relative Auslenkung zeigt.

Zu diesen an sich bekannten Eigenschaftsverbesserungen kommt als erfindungsgemäße Eigenschaft hinzu, daß sich auch hier eine verbesserte Festigkeit im Verbund des Piezoaktors zeigt. Auch diese Keramikzusammensetzung ist nach dem Sintern stöchiometrisch, da die überschüssige (La)-Dotierung während des Sinterns durch Eindiffusion von Silber ausgeglichen wird, und überschüssiges Bleioxid durch Verdampfen aus der Keramik entweicht. Auch hier ergibt sich ein gleichmäßiger Silbergehalt über die Keramikschicht, während Palladium wiederum nur in grenzflächennahen Bereichen in Form der bereits beim ersten Ausführungsbeispiel genannten Pd-Pb-O-haltigen Phasen in den Korngrenzzwickeln 4 nachgewiesen werden kann.

Mit der Erfindung ist es möglich, einen monolithischen Piezoaktor in Vielschichtbauweise darzustellen, der gegenüber bekannten Piezoaktoren eine verbesserte Verbundfestigkeit zeigt, der mit kostengünstigeren Silber/Palladium-haltigen Elektrodenschichten erzeugt werden kann und der völlig unabhängig von einer gegebenenfalls vorhandenen B-Platz-Dotierung auch unterhalb einer an sich optimalen Sintertemperatur zu einer hochwertigen Keramik mit guten piezoelektrischen Eigenschaften gesintert werden kann. Damit ist es insbesondere möglich, Vielschichtaktoren mit Anwendungstemperaturen bis 150°C, hoher mechanischer Belastbarkeit und hoher Zuverlässigkeit auch im dynamischen Betrieb herzustellen.

## Patentansprüche

1. Verfahren zur Herstellung eines Piezoaktors in monolithischer Vielschichtbauweise,
- bei dem zur Herstellung von Piezokeramik-Grünfolien von einem stöchiometrischen Piezokeramikpulver vom Typ PZT ausgegangen wird, zu dem ein stöchiometrischer Überschuß eines heterovalenten Seltenerdmetalls bis zu einem Gesamtgehalt von 1 bis 5 mol% und ein stöchiometrischer Überschuß von zusätzlichen 1-5 mol% an Bleioxid zugegeben wird
- bei dem auf die Grünfolien Elektrodenschichten aus einer silber- und palladiumhaltigen Paste aufgebracht werden
- bei dem die Grünfolien so übereinander gestapelt und anschließend laminiert werden, daß sich im Stapel eine alternierende Abfolge von Grünfolien und Elektrodenschichten ergibt,
- bei dem der laminierte Stapel unter kontrollierten Sinterbedingungen so gesintert wird, daß überschüssiges Bleioxid abdampft und die überstöchiometrische Seltenerd-Dotierung durch Eindiffusion von Silber aus den Elektrodenschichten kompensiert wird,
- bei dem die Sinterung bei einer maximalen Temperatur von 1130°C in oxidierender Atmosphäre durchgeführt wird,
- bei dem während der Sinterung eine Haltephase bei der maximalen Temperatur von 30 bis 120 Minuten eingehalten wird,
- wobei stöchiometrische Piezokeramikschichten (2) mit homogener Silber-Dotierung erhalten werden.

2. Verfahren nach Anspruch 1,
bei dem der PbO Überschuß auf 1 bis 3 mol% eingestellt wird.

3. Verfahren nach einem der Ansprüche 1 oder 2,
bei dem für eine gewünschte Dicke der Elektrodenschichten (1) von 2-4 um (nach dem Sintern) beim Aufbringen der Elektrodenschichten eine höhere Schichtdicke als Schichtdickenvorhalt gewählt wird, die den späteren Schichtdickenverlust durch das Eindiffusion von Silber in die Piezokeramikschicht ausgleicht, und wobei der Schichtdickenvorhalt proportional zum Schichtdickenverhältnis Piezokeramikschicht/Elektrode und zum Dotierstoffgehalt des Seltenerdmetalls bestimmt wird.

4. Verfahren nach einem der Ansprüche 1 bis 3,
bei dem als Seltenerdmetall La oder Nd im stöchiometrischen Überschuß zum Piezokeramikpulver zugegeben wird.

5. Verfahren nach einem der Ansprüche 1 bis 4,
bei dem ein Piezokeramikpulver eingesetzt wird, das eine komplexe B-Platzdotierung besitzt.

## Claims

1. Process for producing a piezoelectric actuator of monolithic multilayer design,
- in which, to produce piezoceramic green films, the starting point is a stoichiometric piezoceramic powder of the PZT type, to which a stoichiometric excess of a heterovalent rare earth metal up to an overall content of 1 to 5 mol% and a stoichiometric excess of an additional 1-5 mol% of lead oxide are added,
- in which electrode layers of a paste containing silver and palladium are applied to the green films,
- in which the green films are stacked on one another and then laminated such that an alternating sequence of green films and electrode layers results in the stack,
- in which the laminated stack is sintered under controlled sintering conditions such that excess lead oxide evaporates off and the hyperstoichiometric rare earth doping is compensated by inward diffusion of silver from the electrode layers,
- in which the sintering is carried out in an oxidizing atmosphere at a maximum temperature of 1130°C,
- in which, during sintering, a holding phase of 30 to 120 minutes at the maximum temperature is maintained,
- stoichiometric piezoceramic layers (2) with homogeneous silver doping being obtained.

2. Process according to Claim 1, in which the PbO excess is set to 1 to 3 mol%.

3. Process according to one of Claims 1 or 2, in which, for a desired thickness of the electrode layers (1) of 2-4 mm (following sintering), at the time of applying the electrode layers a higher layer thickness is selected as a layer thickness allowance which compensates for the subsequent layer thickness loss by the inward diffusion of silver into the piezoceramic layer, and the layer thickness allowance being determined in proportion to the layer thickness ratio of piezoceramic layer to electrode and to the dopant content of the rare earth metal.

4. Process according to one of Claims 1 to 3, in which, as the rare earth metal, La or Nd in stoichiometric excess is added to the piezoceramic powder.

5. Process according to one of Claims 1 to 4, in which a piezoceramic powder which has complex B-site doping is used.

## Revendications

1. Procédé pour la fabrication d'un actionneur piézoélectrique à constitution monolithique à couches multiples
- au cours duquel, pour la fabrication de lamelles brutes de piézocéramique, on part d'une poudre de piézocéramique stoechiométrique du type PZT, à laquelle on ajoute un excédent stoechiométrique d'un métal hétérovalent des terres rares jusqu'à une teneur totale de 1 à 5 pour cents molaires et un excédent stoechiométrique d'oxyde de plomb de 1 - 5 pour cents molaires supplémentaires,
- au cours duquel des couches d'électrodes composées de pâtes contenant de l'argent et du palladium sont appliquées sur les lamelles brutes,
- au cours duquel les lamelles brutes sont empilées l'une sur l'autre, puis stratifiées, de telle sorte qu'on obtient, dans l'empilement, une alternance de lamelles brutes et de couches d'électrodes,
- au cours duquel l'empilement stratifié est fritté sous conditions de frittage contrôlées de telle sorte que de l'oxyde de plomb excédentaire s'évapore et que le dopage surstoechiométrique en terres rares est compensé par diffusion d'argent provenant des couches d'électrodes,
- au cours duquel le frittage est exécuté en atmosphère oxydante à une température maximum de 1.130° C,
- au cours duquel, pendant le frittage, on observe une phase de maintien de 30 à 120 minutes à la température maximum,
- des couches stoechiométriques de piézocéramique (2) à dopage homogène d'argent étant obtenues.

2. Procédé selon la revendication 1
au cours duquel l'excédent de PbO est réglé à 1 à 3 pour cents molaires.

3. Procédé selon l'une des revendications 1 ou 2,
au cours duquel, pour une épaisseur recherchée des couches d'électrodes (1) de 2 - 4 µm (après le frittage), on choisit, lors de l'application des couches d'électrodes, une épaisseur de couche plus élevée comme réserve d'épaisseur de couche, qui compense la perte ultérieure d'épaisseur de couche en raison de la diffusion d'argent dans la couche de piézocéramique, la réserve d'épaisseur de couche étant déterminée proportionnellement au rapport des épaisseurs des couches piézocéramique/électrodes et à la teneur en produit de dopage du métal des terres rares.

4. Procédé selon l'une des revendications 1 à 3
au cours duquel on ajoute à la poudre de piézocéramique, comme métal des terres rares, du La ou du Nd en excédent stoechiométrique.

5. Procédé selon l'une des revendications 1 à 4
au cours duquel on utilise une poudre de piézocéramique ayant un dopage complexe en position B.
